# EUROPÄISCHE PATENTSCHRIFT

(11) **EP 0 611 968 B1**
(45) Veröffentlichungstag und Bekanntmachung des Hinweises auf die Patenterteilung: **31.03.1999**
(21) Anmeldenummer: 94100973.0
(22) Anmeldetag: 24.01.1994
(51) Int. Cl.: G01R 31/28

(54) **Vorrichtung zur Prüfung von Modulen**
Apparatus for testing modules
Dispositif de contrôle des modules

(30) Priorität: 10.02.1993 CH 407/93
(43) Veröffentlichungstag der Anmeldung: 24.08.1994
(73) Patentinhaber: SIEBA AG, 8902 Urdorf (CH)
(72) Erfinder: Rieser, Hansjörg, CH-8353 Elgg (CH); Staubli, Herbert, CH-5444 Künten (CH); Schmoker, Peter, Dr., CH-8215 Hallau (CH)
(74) Vertreter: Wächter, Roland

(56) Entgegenhaltungen:
- EP-A- 0 254 691
- EP-A- 0 346 166
- PATENT ABSTRACTS OF JAPAN vol. 8, no. 72 (P-265) (1509) 4. April 1984 & JP-A-58 218 667 (ANAROGU)

## Beschreibung

Die vorliegende Erfindung betrifft eine Prüfanlage nach dem Oberbegriff des Patentanspruchs 1.

Ein wesentlicher Beitrag zur Sicherstellung der Qualität und Zuverlässigkeit komplexer technischer Systeme wird durch geeignete Prüfungsverfahren während der Fertigungsphase geleistet. Zur Prüfung elektrischer Leiterplatten bzw. Module werden folgende in A. Birolini, Qualität und Zuverlässigkeit technischer Systeme, Springer Verlag, Berlin 1991, 3. Auflage, Seiten 268 - 280 beschriebene Verfahren vereinzelt oder vorzugsweise wechselseitig angewendet : Während einer Vorbehandlungsphase werden die bestückten Module visuell kontrolliert und bezüglich grundlegender Funktionen elektrisch geprüft. Ferner werden thermische Zyklen (z.B. von -20°C bis +80°C bei einem Gradienten von 10°C / min), Vibrationen sowie ein längeres Einlaufen bei normaler Betriebstemperatur vorgesehen. In einer Umwelt- und Zuverlässigkeitsprüfung, in der versteckte Mängel und Zuverlässigkeitsprobleme entdeckt werden sollen, werden Extremtemperaturen, weitere thermische Zyklen, Vibrationen, eine Feuchte- und eine ESD-Prüfung vorgesehen. Die Speisespannung soll bei den obenerwähnten Prüfungen vorzugsweise zuschaltbar sein. Von grundlegender Bedeutung ist ferner die elektrische Prüfung, die bei bekannten Vorrichtungen vor oder nach den obenerwähnten Prüfungen angewendet wird. Dazu wird ein Funktionsprüfgerät vorgesehen, das die Übereinstimmung der Arbeitsweise der getesteten Module mit einem vorgegebenen Sollverhalten feststellt.

**Bei z.B. aus der EP 0 254 691 A2 bekannten Prüfvorrichtungen wurden bisher Wärme- Kälte - oder Feuchtekammern vorgesehen**. Der Vibrationstest erfolgte in einer weiteren Vorrichtung. Die elektrische Prüfung der behandelten Module gestaltete sich daher sehr aufwendig. Die Prüfung innerhalb dieser Kammern während dem Behandlungsvorgang war praktisch nicht durchführbar. Für die thermische Prüfung z. B. wurden längere tunnelförmige Öfen vorgesehen, durch die die vereinzelten Module mit einem Förderband transportiert wurden. Innerhalb dieser Tunnelöfen waren die Module für die elektrische Prüfung naturgemäss nicht zugänglich.

Ferner war der Platzbedarf für diese Kammern, Tunnelöfen, Förderbänder, etc. erheblich, was nebst den hohen Kosten für die Vorrichtungen auch beträchtliche Kosten für die benötigten Räumlichkeiten verursachte. Weiterhin war der Zeitaufwand für die gesamte Qualitätsprüfung sehr hoch, da die Module jeweils innerhalb der Tunnelöfen, zwischen den Kammern und Vorrichtungen bewegt und ausgetauscht werden mussten.

Der vorliegenden Erfindung liegt daher die Aufgabe zugrunde, eine kostengünstige Prüfvorrichtung zu schaffen, mit der eine oder mehrere Qualitätsprüfungen in kürzerer Zeit durchgeführt werden können.

Diese Aufgabe wird durch die im kennzeichnenden Teil des Patentanspruchs 1 angegebenen Massnahmen gelöst. Vorteilhafte Ausgestaltungen der Erfindung sind in weiteren Ansprüchen angegeben.

Die erfindungsgemässe Vorrichtung, die einen geringen Platzbedarf und relativ tiefe Herstellungskosten verursacht, erlaubt die Anwendung verschiedener Prüfverfahren, die sequentiell oder gleichzeitig, d.h. einander ergänzend durchgeführt werden können. Weiterhin lässt sich das Prüfverfahren bzw. der entsprechende Prozess leichter beherrschen. D.h., das Hoch- und Tieffahren der Anlage gelingt in sehr kurzer Zeit. Vereisungsstellen können weitgehend vermieden werden. Zudem können Temperaturprofile individuell definiert und genau geregelt werden. Als weiteren wesentlichen Vorteil erweist sich der einfache und übersichtliche Aufbau der erfindungsgemässen Vorrichtung, die praktisch keine Verschleissteile und daher eine geringe Störanfälligkeit aufweist. Zur niedrigen Störanfälligkeit trägt ferner der Umstand bei, dass funktionelle Vorrichtungsteile (Bänder, Werkstückträger, etc.) nicht dem Temperaturstress in den Klimakammern ausgeliefert sind. Die Kontaktierung der zu prüfenden Module erfolgt bei Raumtemperatur in definierter Atmosphäre. Dadurch werden die Kontakte und die entsprechenden Adapter geschont. Die Umrüstung der Vorrichtung zur Prüfung anderer Modultypen lässt sich einfach und mit nur geringem Aufwand erzielen. Die erfindungsgemässe Prüfvorrichtung bedingt daher nur einen geringen Wartungs- und Bedienungsaufwand.

Die Erfindung wird nachfolgend anhand einer Zeichnung beispielsweise näher erläutert. Dabei zeigt:
- Fig. 1: eine erfindungsgemässe Prüfvorrichtung
- Fig. 2: eine erfindungsgemässe Prüfvorrichtung mit einem Karussell

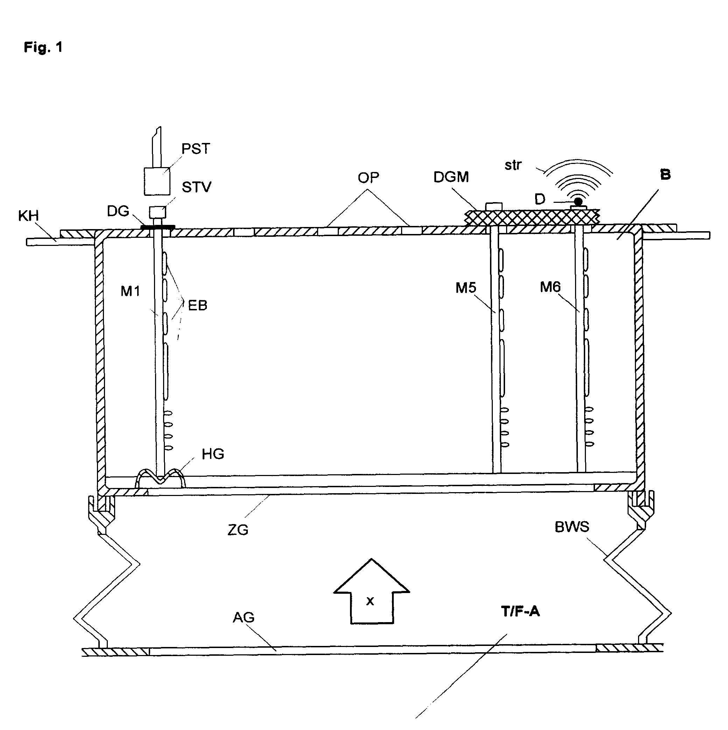

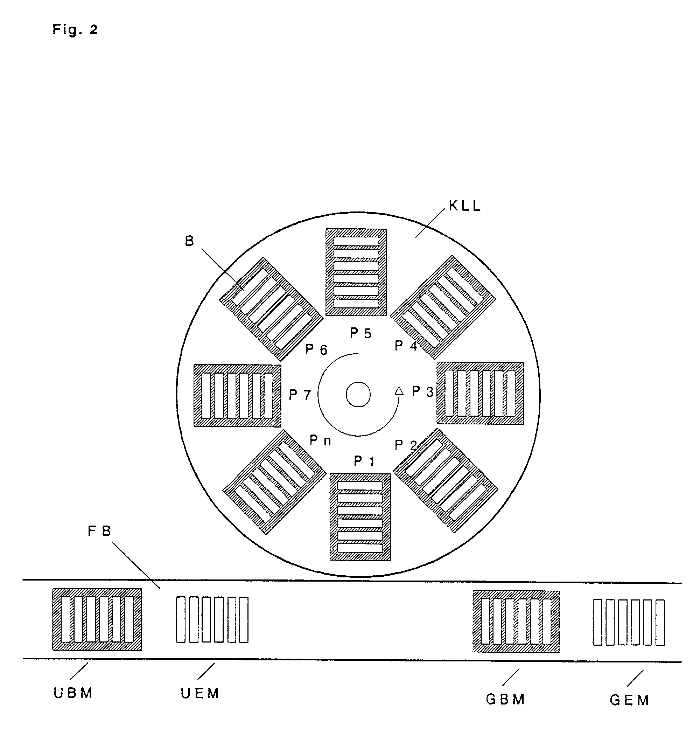

Fig. 1 zeigt einen Behälter B, der mit sechs Öffnungen OP versehen ist, in die drei zu prüfende mit Bauteilen EB bestückte Leiterplatten bzw. Module M1, M5, M6 eingesetzt sind. Die Module M sind entweder an den Rändern der Öffnungen OP aufgehängt oder von einer am Behälterboden vorgesehenen Halterung HG gestützL Ferner können auch seitlich montierte Führungsschienen vorgesehen sein. Die Öffnungen OP, in denen Module M eingelegt sind, sind vorzugsweise durch eine kleinere ein Ende des Moduls umfassende Dichtung DG oder durch eine Dichtungsmatte DGM weitgehend abgedichtet. Im Behälterboden ist ein grösserer Zugang ZG vorgesehen, der zur Zufuhr eines von einem Aggregat T/F-A abgegebenen Mediums x vorgesehen ist, das eine wählbare Temperatur und/oder Feuchtigket aufweist Das Aggregat T/F-A, aus dessen Ausgangsöffnung das Medium x austritt, ist mit dem Behälter B über einen an- und abkoppelbaren Balg BWS verbindbar. Zusätzlich sind nichtgezeichnete Mittel vorgesehen, durch die das Medium x durch den Behälter B zu einem Ausgang in die Umgebung oder vorzugsweise zurück zum Aggregat T/F-A geführt wird. Der Behälter B wird ferner von einer Halterung KH gehalten, die Teil eines Förderbandes oder eines in Fig. 2 gezeigten Karussells KLL ist, das zum Transport der Behälter B vorgesehen ist.

Das auf der linken Seite des Behälters B eingesetzte Modul M1 ist auf der Seite mit einem Steckverbinder STV oder ähnlichen Kontakten versehen, über die ein Funktionsprüfgerät durch einen Stecker PST ankoppelbar ist. Die Funktionsprüfung kann daher gleichzeitig mit dem Ablauf des Prüfverfahrens, z.B. während dem Abfahren eines Temperaturgradienten erfolgen. Dadurch kann nicht nur festgestellt werden, ob eine Modul M ausgefallen ist, sondern es lassen sich auch Fehler ermitteln, die nur bei bestimmten Konditionen auftreten. Das Funktionsprüfgerät kann dadurch direkt in das Prüfverfahren eingreifen, falls es mit dem Aggregat T/F-A gekoppelt wird. Z.B. könnten zu diesem Zweck Temperatur- und weitere Messfühler auf dem Modul M vorgesehen sein. Der Stecker PST und der Steckverbinder STV befinden in der gezeigten Anordnung ausserhalb des Behälters B und sind den thermischen und weiteren Belastungen daher nicht ausgesetzt. Der Behälter B weist vorzugsweise ein relativ kleines Volumen auf. Die gewünschten Temperaturen lassen sich daher schnell und präzise einstellen. Dieses Verhalten kann weiter verbessert werden, falls die Behälter B aus robustem und gut isolierendem Material gefertigt sind. Durch diese Massnahmen lassen sich ferner die vergleichsweise geringen Emissionen der Vorrichtung an die Umgebung zudem noch weiter senken.

Die Behälter B lassen sich ferner leicht für andere Module umrüsten. Z.B. kann die mit den Öffnungen OP versehene Abdeckung der Behälter demontierbar vorgesehen und vorzugsweise verbunden mit den Halterungen HG einem bestimmten Modul M angepasst sein. Die Umrüstung auf andere Module kann daher durch den Austausch des Behälters B oder nur durch den Austausch seiner Abdeckung erfolgen. Von Bedeutung ist ferner, dass in der Klimakammer bzw. in dem in Fig. 1 gezeigten Behälter B praktisch keine Vorrichtungsteile, sondern nur die zu testenden Module M vorgesehen sind. Die meisten Vorrichtungsteile (codierte Werkstückträger, Antriebs- und Förderteile) sind den Prüfbedingungen (Temperaturschwankungen, etc.) daher nicht ausgesetzt und in ihrer normal zu erwartenden Lebensdauer nicht beschränkt. Durch den einfachen Aufbau der Vorrichtung, wie dies aus Fig. 1 ersichtlich ist, ergeben sich daher geringe Herstellungs- und Wartungskosten.

In Fig. 2 ist ein Karussell KLL gezeigt, in das acht mit Modulen M versehene Behälter B eingesetzt sind. Die Module M werden dabei vereinzelt oder bereits in Behälter B eingesetzt über ein Förderband FB zu- und nach dem Prüfverfahren wiederum vereinzeit oder in Behältern B weggeführt. Zum Beladen des Karussells KLL werden daher ganze Behälter B ausgetauscht oder einzelne Module M ausgetauscht. Der Prüfvorgang läuft beispielsweise wie folgt ab. An der Position P1 des Karussells KLL werden die Module M einzeln oder in Behältern B gebündelt ausgetauscht. Das Karussell KLL dreht sich danach um 45°, wonach sich der Behälter an Position P2 befindet An dieser Stelle wird der Balg eines Aggregats T/F-A hochgefahren, wonach das Medium x in den Behälter eingeführt wird oder es wird ein Vibrationsgerät angeschlossen. An Position P2 kann z.B. vorgekühlt, an den folgenden Positionen P3, ..., Pn weiter gekühlt oder erwärmt und/oder Feuchtigkeit zugeführt oder entnommen werden. An vereinzelten Stellen kann die Speisespannung zu- oder abgeschaltet werden. Ferner kann an einer oder mehreren Positionen P ein Prüfstecker PST oder ein oben erwähnter z.B. optischer Sensor vorgesehen sein. Durch die Anordnung mit Karussell KLL lassen sich Module M auf engem Raum in hoher Dichte daher schnell und gründlich prüfen. Weniger günstig wäre das Einsetzen in ein Förderband (z.B. Förderband FB), das die Behälter B zu den Aggregaten T/F-A führen würde. Trotzdem kann auch eine derartige Vorrichtung bei entsprechenden Raumverhältnissen vorteilhaft zur Anwendung gelangen.

In einer weiteren bevorzugten Ausführung ist der Behälter B mit Speisespannungsleitungen versehen, die zu jeder Öffnung OP geführt und über Kontakte mit den Modulen M und einer beispielsweise auf dem Karussell KLL vorgesehenen Stromversorgungseinheit verbunden sind. Mit dem Einsetzen der Module M im Behälter B und dem Einsetzen der Behälter B im Karussell entsteht die Verbindung zur vorzugsweise steuerbaren Stromversorgungseinheit. Die Module M können daher im aus- oder eingeschalteten Zustand thermischen Zyklen oder anderen Prüfverfahren unterzogen werden. Vorzugsweise ist auf der aus dem Behälter B ragenden Seite eine Leuchtdiode D oder eine weitere akustische, elektrische oder optische Sendeeinheit vorgesehen, über die ein auf dem Modul M vorgesehener Prozessor laufend Statusmeldungen str abgeben kann. Ohne das Funktionsprüfgerät galvanisch anschliessen zu müssen gelingt es dadurch, alle wesentlichen Funktionen der Module M zu prüfen. Dadurch entfallen elektrische Koppelvorrichtungen und damit allenfalls verbundene Kontaktierungsprobleme. Vorzusehen ist lediglich ein optischer Sensor, der die von den Modulen abgegebenen Signale an das Funktionsprüfgerät abgibt. Im Modul M ist ferner ein Testprogramm vorzusehen, das über den Prozessor verschiedene Bauteile EB aktiviert, entsprechende Messsignale sammelt und eine mit Startsignalen versehene Statusmeldung periodisch absendet.

## Patentansprüche

1. Vorrichtung zur Prüfung von Modulen (M) mit wenigstens einem Behälter (B), der Öffnungen (OP) aufweist, in die Module (M) derart einfügbar sind, dass die Öffnungen (OP) zumindest annähernd dicht abgeschlossen sind und mit einem Aggregat (T/F-A), das zur Änderung des Klimas innerhalb des Behälters (B) geeignet ist, **dadurch gekennzeichnet**, dass eine Fördervorrichtung (KLL; FB) vorgesehen ist, durch die der Behälter (B) von einem Aufnahmeort zumindest zum Aggregat (T/F-A) und weiter zu einem Abgabeort transportierbar ist und dass der Behälter (B) mindestens einen Zugang (ZG) aufweist, der mit einem Ausgang (AG) des Aggregats (T/F-A) verbindbar ist, das über den Ausgang (AG) zur Abgabe eines Mediums (x) von wählbarer Temperatur geeignet ist.

2. Vorrichtung nach Anspruch 1, **dadurch gekennzeichnet**, dass der Zugang (ZG) für das Medium (x) auf der Unterseite des Behälters (B) vorgesehen und über einen Balg (BWS) mit dem Ausgang (AG) des Aggregats (T/F-A) verbindbar ist.

3. Vorrichtung nach Anspruch 1 oder 2, **dadurch gekennzeichnet**, dass die Fördervorrichtung (KLL; FB) ein Karussell oder ein Förderband ist.

4. Vorrichtung nach einem der vorhergehenden Ansprüche, **dadurch gekennzeichnet**, dass die Module (M) mit vorzugsweise optischen Sendevorrichtungen (D) oder Kontakten (STV) versehen sind, die nach dem Einsetzen der Module (M) in den Behälter (B) von aussen durch ein Funktionsprüfgerät zugänglich sind.

5. Vorrichtung nach Anspruch 4, **dadurch gekennzeichnet**, dass das an das Modul (M) ankoppelbare Funktionsprüfgerät mit dem Aggregat (T/F-A) verbunden ist und dass der Feuchtezufuhr-, Kühl- oder Erwärmungsvorgang in Abhängigkeit der vom Funktionsprüfgerät gemessenen Werte steuerbar ist.

6. Vorrichtung nach einem der vorhergehenden Ansprüche, **dadurch gekennzeichnet**, dass eine Vibrationsvorrichtung vorgesehen ist, der die Behälter (B) zuführbar sind.

7. Vorrichtung nach einem der vorhergehenden Ansprüche, **dadurch gekennzeichnet**, dass die Behälter (B) Kontakte aufweisen, über die zumindest die Speisespannung den im Behälter (B) enthaltenen Modulen (M) zuführbar ist.

## Claims

1. Apparatus for testing modules (M) having at least one container (B) which has openings (OP) into which modules (M) can be inserted in such a way that the openings (OP) are sealed at least approximately tightly, and having a unit (T/F-A) which is suitable for changing the climate within the container (B), characterized in that a conveyor apparatus (KLL;FB) is provided, by means of which the container (B) can be transported from a receiving site at least to the unit (T/F-A) and further to a delivery site, and in that the container (B) has at least one access (ZG) which can be connected to an output (AG) of the unit (T/F-A) which is suitable for the delivery of a medium (x) of selectable temperature by way of the output (AG).

2. Apparatus according to claim 1, characterized in that the access (ZG) for the medium (x) is provided on the lower side of the container (B) and can be connected to the output (AG) of the unit (T/F-A) by way of bellows (BWS).

3. Apparatus according to claim 1 or 2, characterized in that the conveyor apparatus (KLL; FB) is a carousel or a conveyor belt.

4. Apparatus according to one of the preceding claims, characterized in that the modules (M) are provided with preferably optical transmission devices (D) or contacts (STV) which, after the insertion of the modules (M) into the container (B), are accessible from the outside by way of a function testing device.

5. Apparatus according to claim 4, characterized in that the function testing device which can be coupled to the module (M) is connected to the unit (T/F-A) and in that the moisture supply, cooling or heating procedure is controllable in dependence upon the values measured by the function testing device.

6. Apparatus according to one of the preceding claims, characterized in that a vibration apparatus is provided, to which the containers (B) can be supplied.

7. Apparatus according to one of the preceding claims, characterized in that the containers (B) have contacts by way of which at least the supply voltage can be supplied to the modules (M) contained in the container (B).

## Revendications

1. Installation de contrôle de modules (M) comportant au moins un récipient (B), qui a des ouvertures (OP) dans lesquelles des modules (M) peuvent être insérés de telle sorte que les ouvertures (OP) sont fermées de manière au moins sensiblement étanche, et un groupe (T/F-A), qui est destiné à modifier la climatisation à l'intérieur du récipient (B), **caractérisée par le fait qu**'il est prévu un dispositif de transport (KKL ; FB) par lequel le récipient (B) peut être transporté d'un lieu de réception au moins vers le groupe (T/F-A) et plus loin vers un lieu de sortie et que le récipient (B) comporte au moins un accès (ZG) qui peut être relié à une sortie (AG) du groupe (T/F-A), qui permet d'envoyer, par l'intermédiaire de la sortie (AG), un fluide (x) dont la température peut être choisie.

2. Installation selon la revendication 1, **caractérisée par le fait que** l'accès (ZG) pour le fluide (x) est prévu sur la face inférieure du récipient (B) et peut être relié par l'intermédiaire d'un soufflet (BWS) à la sortie (AG) du groupe (T/F-A).

3. Installation selon la revendication 1 ou 2, **caractérisée par le fait que** le dispositif de transport (KLL ; FB) est un carrousel ou une bande convoyeuse.

4. Installation selon l'une des revendications précédentes, **caractérisée par le fait que** les modules (M) sont munis de préférence de dispositifs émetteurs optiques (D) ou de contacts (STV) qui, après le rangement des modules (M) dans le récipient (B), sont accessibles de l'extérieur par un appareil de contrôle de fonctionnement.

5. Installation selon la revendication 4, **caractérisée par le fait que** l'appareil de contrôle de fonctionnement pouvant être couplé au module (M) est relié en groupe (T/F-A) et que l'opération d'amenée d'humidité, de refroidissement ou de chauffage peut être commandée en fonction des valeurs mesurées par l'appareil de contrôle de fonctionnement.

6. Installation selon l'une des revendications précédentes, **caractérisée par le fait qu**'il est prévu un dispositif à vibrations, auquel les récipients (B) peuvent être amenés.

7. Installation selon l'une des revendications précédentes, **caractérisée par le fait que** les récipients (B) comportent des contacts par l'intermédiaire desquels au moins la tension d'alimentation peut être amenée aux modules (M) contenus dans le récipient (B).
